# EUROPEAN PATENT APPLICATION

(11) **EP 4 831 366 A1**
(43) Date of publication of application: **28.10.2026**
(21) Application number: 24906965.9
(22) Date of filing: 08.11.2024
(51) Int. Cl.: C30B 29/36, C23C 16/42, C30B 25/18, H01L 21/205

(54) **METHOD FOR MANUFACTURING HETEROEPITAXIAL WAFER**

(30) Priority: 22.12.2023 JP 2023216659
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP); MATSUBARA, Toshiki, Nishishirakawa-gun, Fukushima 961-8061 (JP); SUZUKI, Atsushi, Nishishirakawa-gun, Fukushima 961-8061 (JP); ABE, Tatsuo, Nishishirakawa-gun, Fukushima 961-8061 (JP)
(74) Representative: Schicker, Silvia
(86) International application number: PCT/JP2024/039754
(87) International publication number: WO 2025/134577

(57) **Abstract**

The present invention is a method for manufacturing a heteroepitaxial wafer, epitaxially growing a 3C-SiC single crystal film on a single crystal silicon substrate, the method including the steps of: providing a single crystal silicon substrate having a plane orientation of (111); removing a natural oxide film on a surface of the single crystal silicon substrate by hydrogen baking using a flashlamp apparatus; and supplying a source gas containing carbon and silicon into the flashlamp apparatus and growing a SiC single crystal on the surface of the single crystal silicon substrate, in which in the step of removing the natural oxide film, the hydrogen baking is performed at 900°C or higher and 1350°C or lower after preheating at 300°C or higher and 600°C or lower, and in the step of growing the SiC single crystal, SiC nucleation is performed at 900°C or higher and 1350°C or lower after preheating at 300°C or higher and 600°C or lower. This provides a method for manufacturing a heteroepitaxial wafer that efficiently yields epitaxial growth of the 3C-SiC single crystal film with good quality on the single crystal silicon substrate.

## Description

### TECHNICAL FIELD

The present invention relates to a method for manufacturing a heteroepitaxial wafer.

### BACKGROUND ART

SiC, which has a wide bandgap of 2.2 to 3.3 eV, has a high dielectric breakdown strength, and has a large thermal conductivity. SiC is thus a material expected as a semiconductor material for semiconductor devices such as power devices and high-frequency devices.

In addition, use of SiC as a platform for gallium nitride (GaN) growth is also in progress (for example, Patent Document 1 and Non Patent Document 1), but SiC wafers are typically of small diameters, and large diameters are required for the power devices and the high-frequency devices. Formation of a 3C-SiC single crystal film with good quality on a large-diameter substrate enables to produce a large-diameter heteroepitaxial wafer having a GaN layer with good quality, in addition to use of the 3C-SiC single crystal film itself.

Accordingly, as a method for increasing the diameter, epitaxial growth on a silicon (hereinafter, also referred to as Si) substrate having good compatibility with device process has been investigated (for example, Patent Documents 1 and 2). These Patent Documents disclose that a 3C-SiC single crystal film can grow on a silicon substrate and that a 3C-SiC single crystal film can grow on a large-diameter substrate, such as a substrate with 300 mm in diameter, by selecting a type of a reactor. In the formation of the 3C-SiC single crystal film in these Patent Documents, two raw material gases of a gas containing a carbon source precursor and a gas containing a silicon source precursor are introduced into a reactor together with a carrier gas, and these raw material gases are decomposed for the growth by a high-temperature treatment (up to 1200°C) or by combination of the high-temperature treatment and a plasma treatment.

In addition, as an example of the growth of the 3C-SiC single crystal film on the silicon substrate, Patent Document 3 discloses use of a single crystal silicon substrate with a plane orientation (110) as the single crystal silicon substrate to further reduce lattice mismatch between silicon and SiC. Although the use is advantageous in terms of lattice mismatch, limiting the plane orientation to (110) is undesirable when the production of the heteroepitaxial wafer is considered. In addition, Patent Document 3 also discloses formation of a 3C-SiC single crystal layer containing hydrogen, but hydrogen is expected to be easily eliminated during temperature raising in the epitaxial growth sequence, and a condition independent of the hydrogen amount is desired.

In addition, Patent Document 4 mentions an off-angle of the single crystal silicon substrate, but mentioned are carbonization of propane and subsequent growth of propane + silane gas. This growth increases the number of types of the raw material gas, which is disadvantageous for the epitaxial growth.

In addition, Patent Document 5 discloses a method of growing a 3C-SiC single crystal layer on a single crystal silicon substrate with a plane orientation of (111) and a diameter of smaller than 8 inches by using monomethylsilane as a raw material gas. In this case, the film is formed under the following condition: a temperature of the single crystal silicon substrate reaches a film formation condition of 1050 to 1100°C, and then a pressure in a chamber of 2×10⁻⁴ to 3×10⁻⁴ Torr (0.02 to 0.03 Pa) for a period of 5 to 12 hours. In the method, the 3C-SiC single crystal layer is formed under the condition with extremely low pressure, and thus the method has a problem of a low film forming speed.

Various formation methods are developed and proposed as described above, but considering lattice constants of silicon and SiC, it is preferred to use a Si (111) substrate (the lattice constant of Si (111): 3.84 Å, which is close to the lattice constant of 3C-SiC: 4.36 Å). However, even when Si (111) is used in consideration of the lattice constants as conventional and with further devising growth conditions, there has been a problem of improvement in crystallinity of the 3C-SiC single crystal film.

### CITATION LIST

### PATENT LITERATURE

Patent Document 1: JP 2018-522412 A
Patent Document 2: JP 2021-20819 A
Patent Document 3: JP 2006-253617 A
Patent Document 4: JP 2008-184361 A
Patent Document 5: JP 2017-39622 A

### NON PATENT LITERATURE

Non Patent Document 1: Japanese Journal of Applied Physics 53, 05FL09 (2014)
Non Patent Document 2: Journal of the Japanese Association for Crystal Growth, Vol. 43, No. 4, 213

### SUMMARY OF INVENTION

### TECHNICAL PROBLEM

As a reason for the above, it is known that the Si (111) substrate surface causes phase transition within a narrow temperature band near 860°C (Non Patent Document 2), as a result of further detailed investigation on a surface structure of the Si substrate, which has not been considered conventionally. Either side of this temperature band, the phase changes to a 7×7 structure on the lower temperature side and to a 1×1 structure on the higher temperature side. Therefore, it has been difficult to form a clear 3C-SiC/Si interface because the surface structure undergoes transition due to temperature increase. Of course, it can be considered that the growth is performed at a temperature lower than that for the phase transition, but such growth becomes island-like growth due to the low surface energy. Thus, the problem specific to the Si (111) surface inhibits growth of the 3C-SiC single crystal film.

In addition, Si (110) further tends to cause low temperature and appearance of various surface structures compared with Si (111), and is accordingly hard to use as the substrate. Further, although Si (100) does not cause such phase transition (to be precise, a 4×4 structure, etc. are reported, but it is behavior in a high-vacuum state), Si (100) is disadvantageous in terms of the lattice constant (5.4 Å, which is far from the lattice constant of 3C-SiC (4.36 Å)).

The present invention has been made to solve the above problem. An object of the present invention is to provide a method for manufacturing a heteroepitaxial wafer that efficiently yields epitaxial growth of the 3C-SiC single crystal film with good quality on the single crystal silicon substrate.

### SOLUTION TO PROBLEM

To solve the above problem, the method for manufacturing a heteroepitaxial wafer of the present invention is a method for manufacturing a heteroepitaxial wafer, epitaxially growing a 3C-SiC single crystal film on a single crystal silicon substrate, the method comprising the steps of: providing a single crystal silicon substrate having a plane orientation of (111); removing a natural oxide film on a surface of the single crystal silicon substrate by hydrogen baking using a flashlamp apparatus; and supplying a source gas containing carbon and silicon into the flashlamp apparatus and growing a SiC single crystal on the surface of the single crystal silicon substrate, wherein in the step of removing the natural oxide film, the hydrogen baking is performed at 900°C or higher and 1350°C or lower after preheating at 300°C or higher and 600°C or lower, and in the step of growing the SiC single crystal, SiC nucleation is performed at 900°C or higher and 1350°C or lower after preheating at 300°C or higher and 600°C or lower.

By the method for manufacturing a heteroepitaxial wafer as above, the 3C-SiC single crystal film can be certainly formed by growing the SiC single crystal after the natural oxide film on the single crystal silicon substrate surface is removed. In addition, due to use of the flashlamp apparatus, which has a fast start-up and can control the temperature in a short time, a large-diameter substrate can be handled. In addition, in the step of removing the natural oxide film, the hydrogen baking is performed at 900°C or higher and 1350°C or lower after preheating at 300°C or higher and 600°C or lower, and in the step of growing the SiC single crystal, SiC nucleation is performed at 900°C or higher and 1350°C or lower after preheating at 300°C or higher and 600°C or lower. Accordingly, the preheating is performed at the temperature of 300°C or higher and 600°C or lower, namely a temperature sufficiently lower than 860°C being the phase transition temperature of Si

(111), in both the steps. Thus, the phase transition can be prevented in the preheating. Further, transfer from the temperature band 300°C or higher and 600°C or lower to the temperature band 900°C or higher and 1350°C or lower can be achieved in a short time with the flashlamp apparatus. Thus, the temperature can be passed through the phase transition temperature in an extremely short time, which can control the temperature to cause almost no phase transition even during temperature band transfer.

By the above, the heteroepitaxial wafer in which the 3C-SiC single crystal film with good quality is epitaxially grown can be efficiently manufactured while inhibiting the phase transition of the single crystal silicon substrate by the simple manufacturing process.

In addition, a time for the hydrogen baking at 900°C or higher and 1350°C or lower is preferably set to 10 milliseconds or more and 100 milliseconds or less, and a time for the SiC nucleation at 900°C or higher and 1350°C or lower is preferably set to 1 millisecond or more and 20 milliseconds or less.

Setting the times as above can achieve required times as the time for the hydrogen baking to remove the natural oxide film and the time for the nucleation to grow the SiC single crystal while setting the times to be as short as possible. As above, setting the staying time within the temperature band higher than 860°C being the phase transition temperature of Si (111) to be the short times can inhibit the phase transition during stay as much as possible. In addition, since the shorter staying time more accelerates temperature lowering after heating, it can be controlled that the phase transition hardly occurs even in temperature lowering. Further, since both the staying time and the time for temperature change become short, the time for manufacturing can be shortened, and the heteroepitaxial wafer having the 3C-SiC single crystal film can be efficiently manufactured.

In addition, the source gas is preferably at least one of monomethylsilane and trimethylsilane.

The raw material gas as above, which is a gas containing both Si and C to be the raw material for SiC, can supply both Si and C with the single gas. Accordingly, a step of performing nucleation by attaching carbon atoms onto a surface of a single crystal silicon single crystal substrate with a gas containing a carbon source precursor, which is called "carbonization treatment", before the growth of the 3C-SiC single crystal film used conventionally is no longer required, and the 3C-SiC single crystal film can be formed in the extremely simple step.

### ADVANTAGEOUS EFFECTS OF INVENTION

By the method for manufacturing a heteroepitaxial wafer of the present invention, the 3C-SiC single crystal film can be certainly formed by growing the SiC single crystal after the natural oxide film on the single crystal silicon substrate surface is removed. In addition, due to use of the flashlamp apparatus, which has a fast start-up and can control the temperature in a short time, a large-diameter substrate can be handled. In addition, in the step of removing the natural oxide film, the hydrogen baking is performed at 900°C or higher and 1350°C or lower after preheating at 300°C or higher and 600°C or lower, and in the step of growing the SiC single crystal, SiC nucleation is performed at 900°C or higher and 1350°C or lower after preheating at 300°C or higher and 600°C or lower. Accordingly, the preheating is performed at the temperature of 300°C or higher and 600°C or lower, namely a temperature sufficiently lower than 860°C being the phase transition temperature of Si (111), in both the steps. Thus, the phase transition can be prevented in the preheating. Further, transfer from the temperature band 300°C or higher and 600°C or lower to the temperature band 900°C or higher and 1350°C or lower can be achieved in a short time with the flashlamp apparatus. Thus, the temperature can be passed through the phase transition temperature in an extremely short time, which can control the temperature to cause almost no phase transition even during temperature band transfer.

Accordingly, the heteroepitaxial wafer in which the 3C-SiC single crystal film with good quality is epitaxially grown can be efficiently manufactured while inhibiting the phase transition of the single crystal silicon substrate by the simple manufacturing process.

### BRIEF DESCRIPTION OF DRAWINGS

[FIG. 1] is a flowchart describing one example of the method for manufacturing a heteroepitaxial wafer of the present invention.
[FIG. 2] is a schematic view (a) of a treatment sequence and a graph (b) showing an XRD spectrum in Example 1.
[FIG. 3] is a schematic view (a) of a treatment sequence and a graph (b) showing an XRD spectrum in Comparative Example 1.

### DESCRIPTION OF EMBODIMENTS

Hereinafter, the present invention will be described in detail, but the present invention is not limited thereto.

As noted above, there has been a demand for providing the method for manufacturing a heteroepitaxial wafer that efficiently yields epitaxial growth of the 3C-SiC single crystal film with good quality on the single crystal silicon substrate.

The present inventors have earnestly studied the above problem, and consequently ascertained that the Si (111) substrate surface causes phase transition within a narrow temperature band near 860°C to consequently change to a 7×7 structure on the lower temperature side and to a 1×1 structure on the higher temperature side across this temperature band, which contributes to generation of defects. That is, a conventional process of forming an initial seed in growing 3C-SiC using the Si (111) substrate from a low temperature while a carbonizing gas flowing takes advantage of this phase transition. An unstable (a high surface-energy) position of a structure portion adjacent to the 7×7 domain at low temperature has been used as an origin (the seed) for the crystal growth, and then the temperature has been raised to grow 3C-SiC. However, it has been difficult to form a clear 3C-SiC/Si interface due to transition of the surface structure by rise in the temperature. Of course, it can be considered that the growth is performed at a temperature lower than that for the phase transition, but such growth becomes island-like growth due to the low surface energy. To solve the problem specific to the Si (111) surface as above, the present inventors have investigated the method of rapidly passing through specifically the phase transition temperature band, and consequently found a method that can control the temperature to hardly cause the phase transition and that can grow the 3C-SiC single crystal having few defects and good quality by passing the temperature through these temperature bands in a short time. This finding has led to completion of the present invention.

Specifically, the method for manufacturing a heteroepitaxial wafer of the present invention is a method for manufacturing a heteroepitaxial wafer, epitaxially growing a 3C-SiC single crystal film on a single crystal silicon substrate, the method including the steps of: providing a single crystal silicon substrate having a plane orientation of (111); removing a natural oxide film on a surface of the single crystal silicon substrate by hydrogen baking using a flashlamp apparatus; and supplying a source gas containing carbon and silicon into the flashlamp apparatus and growing a SiC single crystal on the surface of the single crystal silicon substrate, wherein in the step of removing the natural oxide film, the hydrogen baking is performed at 900°C or higher and 1350°C or lower after preheating at 300°C or higher and 600°C or lower, and in the step of growing the SiC single crystal, SiC nucleation is performed at 900°C or higher and 1350°C or lower after preheating at 300°C or higher and 600°C or lower.

Hereinafter, embodiments of the present invention will be described regarding the drawings.

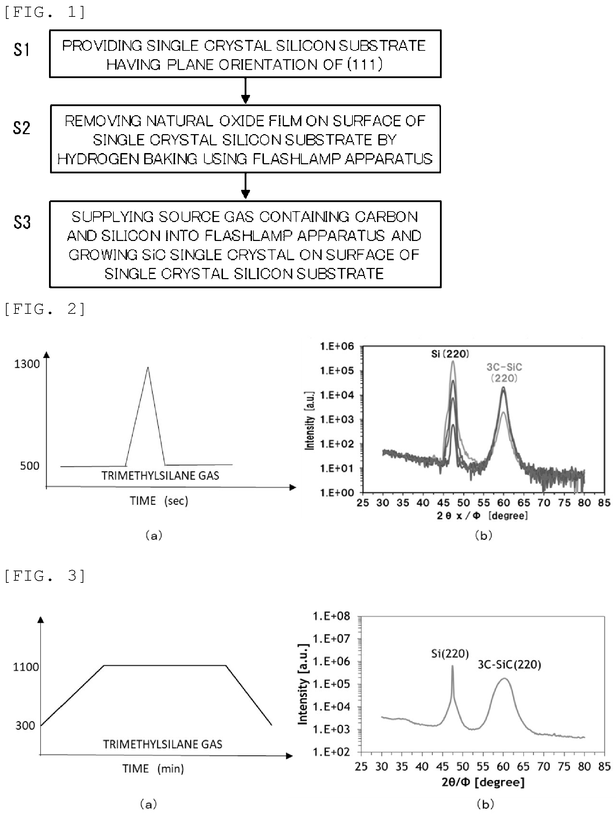

FIG. 1 is a flowchart describing one example of the method for manufacturing a heteroepitaxial wafer of the present invention. Regarding Step S1 to Step S3 in FIG. 1, each step of the manufacturing method will be described.

### (Step S1)

First, Step S1 is a step of providing a single crystal silicon substrate having a plane orientation of (111). The single crystal silicon substrate is disposed in a flashlamp apparatus.

### (Step S2)

Next, Step S2 is a step of removing a natural oxide film on a surface of the single crystal silicon substrate by hydrogen baking using a flashlamp apparatus.

The natural oxide film on the surface is removed by hydrogen baking (H₂ annealing). If the oxide film remains, SiC nucleation on the single crystal silicon substrate is impossible. Thus, the natural oxide film is removed to avoid this failure. In the H₂ annealing in this time, the substrate is preheated under a condition of 300°C or higher and 600°C or lower, which is sufficiently lower than 860°C being the phase transition temperature, and then the temperature for removing the natural oxide film on the single crystal silicon substrate surface is set to 900°C or higher and 1350°C or lower. This is to inhibit damage of the wafer due to thermal stress with drastic rise in temperature, which is caused in the hydrogen baking at 900°C or higher and 1350°C or lower with the flashlamp apparatus if the preheating performed at 300°C or higher and 600°C or lower is not performed.

Here, the temperature range can be more preferably set to, but not particularly limited to, 1000°C or higher and 1200°C or lower. A low temperature requires increase in a treatment time for preventing the remaining of the natural oxide film, and the temperature is more preferably set to 1000°C or higher, if possible. In contrast, since a high temperature accordingly increases concern about generation of slipping, the temperature is more preferably set to 1200°C or lower, if possible. A pressure and a time for the H₂ annealing in this time may be any as long as the natural oxide film can be removed, and there is no specific limitation.

Further, the time for the hydrogen baking at 900°C or higher and 1350°C or lower is preferably set to 10 milliseconds or more and 100 milliseconds or less. The combination of the temperature range and the time as above can shorten the staying time within the temperature band higher than 860°C being the phase transition temperature of Si (111) as much as possible while achieving the time required for removing the natural oxide film.

Note that, when the temperature range is set to 1000°C or higher and 1200°C or lower, the range of the time can be set to, but not particularly limited to, 20 milliseconds or more and 60 milliseconds or less, for example.

### (Step S3)

Next, Step S3 is a step of supplying a source gas containing carbon and silicon into the flashlamp apparatus and growing a SiC single crystal on the surface of the single crystal silicon substrate.

First, the substrate is preheated under a condition at a temperature of 300°C or higher and 600°C or lower, which is sufficiently lower than 860°C being the phase transition temperature of Si (111), and then SiC nucleation is performed at 900°C or higher and 1350°C or lower. This is to inhibit damage of the wafer due to thermal stress with drastic rise in temperature, which is caused in the nucleation at 900°C or higher and 1350°C or lower with the flashlamp apparatus if the preheating performed at 300°C or higher and 600°C or lower is not performed.

Here, the source gas is preferably at least one of monomethylsilane and trimethylsilane. Since C is a smaller atom and more volatile than Si, although not particularly limited, trimethylsilane is more preferable with considering the raw material efficiency, and the conditions are easily set with trimethylsilane.

The time for the SiC nucleation at 900°C or higher and 1350°C or lower is preferably set to 1 millisecond or more and 20 milliseconds or less. The combination of the temperature range and the time as above can shorten the staying time within the temperature band higher than 860°C being the phase transition temperature of Si (111) as much as possible while achieving the time required for growing the SiC single crystal.

Here, the temperature range can be more preferably set to, but not particularly limited to, 1100°C or higher and 1300°C or lower. In addition, when the temperature range is set to 1100°C or higher and 1300°C or lower, the time can be more preferably set to, but not particularly limited to, 5 milliseconds or more and 10 milliseconds or less.

By the above, the heteroepitaxial wafer in which the 3C-SiC single crystal film with good quality is epitaxially grown can be efficiently manufactured while inhibiting the phase transition of the single crystal silicon substrate by the simple manufacturing process of Step S1 to Step S3.

Note that, although not particularly limited, manufacturing while managing the pressure in the step of growing the SiC single crystal of Step S3, such that a flashlamp apparatus having a reducing-pressure (RP) mechanism is used, is more preferable.

Specifically, it is more preferable that the pressure be set to 100 Torr or less in the preheating at 300°C or higher and 600°C or lower, and then the pressure be set to 10 Torr or less in the SiC nucleation at 900°C or higher and 1350°C or lower. The SiC nucleation under the pressure and temperature conditions for achieving the SiC nucleation easily enables more efficient manufacturing of the heteroepitaxial wafer having a target thickness of the 3C-SiC single crystal film.

First, setting the pressure in the preheating to 100 Torr or less can prevent secondary or higher order reactions such that the reaction active species react with the raw material gas in the gas phase, which can achieve the SiC nucleation treatment more certainly.

Next, setting the pressure in the SiC nucleation to 10 Torr or less can grow the 3C-SiC single crystal film and can form pores in a silicon layer directly under this 3C-SiC single crystal film. The presence of these pores can relax lattice mismatch between 3C-SiC and silicon, and can also relax stress of the entirety of the epitaxial layer. Thus, even when a thick 3C-SiC single crystal film is subsequently grown, the 3C-SiC single crystal film without crystal defects can be formed.

Note that, as for the source gas, compared with a conventional two-step method including nucleation by attaching carbon atoms onto the single crystal silicon substrate surface with a gas containing a carbon source precursor and then forming the 3C-SiC single crystal film with a gas containing a carbon source precursor and a gas containing a silicon source precursor, the reaction active species in the gas phase are easily controlled to ensure the growth, and the single crystal film can be formed without stopping the growth of the 3C-SiC single crystal.

Note that, a thin 3C-SiC film having a film thickness of about 2 nm can be formed in the above case. In addition, using the 3C-SiC single crystal film grown as above as a seed layer also for the SiC nucleation and further using the RP-CVD apparatus, etc. can grow a thick 3C-SiC crystal with good quality.

### EXAMPLE

Hereinafter, the present invention will be more specifically described with showing Example and Comparative Example of the present invention, but the present invention is not limited to these Examples.

### [Example 1]

Description will be made regarding FIG. 2. FIG. 2 is a schematic view (a) of a treatment sequence and a graph (b) showing an XRD spectrum in Example 1.

A boron-doped single crystal silicon substrate (111) having a diameter of 300 mm and a resistivity of 10 Ω·cm was provided, the single crystal silicon substrate was disposed in a flashlamp apparatus, and a natural oxide film on the surface was removed by hydrogen baking (H₂ annealing). In the H₂ annealing in this time, the substrate was preheated at 500°C, which was sufficiently lower than 860°C being the phase transition temperature, and then annealed at 1150°C for 40 milliseconds.

Then, the substrate was preheated with trimethylsilane gas being a source gas containing carbon and silicon at 100 sccm, at 10 Torr in the chamber, and at a temperature of 500°C, which was sufficiently lower than 860°C being the phase transition temperature of Si (111), and thereafter, SiC was grown on the single crystal silicon substrate at 1300°C for 10 milliseconds. Here, an image for feeding the gas for 10 milliseconds was an image with a narrow pulse as shown in the schematic view FIG. 2(a) of the treatment sequence.

The crystallinity of the 3C-SiC single crystal film formed on the Si (111) substrate as above was evaluated by X-ray diffraction (XRD) with in-plane arrangement. The in-plane arrangement can provide strong diffraction intensity even with a thin film. Here, a Si (220) plane of the substrate was used as a standard, and a type of an orientation plane of 3C-SiC parallel thereto is determined to judge whether 3C-SiC is single crystal or polycrystal and to yield information about the crystallinity from a half-value width of a 3C-SiC peak. In Example 1, the peak derived from 3C-SiC was only (220) orientation as in FIG. 2(b). That is, a peak derived from another plane index indicating polycrystal was not observed, and it was observed that the single crystal 3C-SiC film was grown.

### [Comparative Example 1]

Description will be made regarding FIG. 3. FIG. 3 is a schematic view (a) of a treatment sequence and a graph (b) showing an XRD spectrum in Comparative Example 1.

A boron-doped single crystal silicon substrate (111) having a diameter of 300 mm and a resistivity of 10 Ω·cm was provided, and hydrogen baking was performed with an epi-furnace at 1130°C.

Then, while flowing trimethylsilane gas at 100 sccm, the temperature was raised from 300°C to 1100°C at 10°C/min. The pressure in this time was set to 100 Torr. Here, an image for feeding the gas was a wide image as shown in the schematic image of the treatment sequence of FIG. 3(a). As for the time for which the substrate was exposed to a temperature higher than 860°C being the phase transition temperature, the substrate in Comparative Example 1 was exposed to the high temperature for a considerably long time compared with Example 1 (FIG. 2(a)).

Thereafter, the crystallinity of the grown 3C-SiC film was measured by XRD with in-plane arrangement. As for the result, only the peak of 3C-SiC (220) parallel to Si (220) appeared as FIG. 3(b), but the peak was low and wide, and accordingly had a large half-value width compared with Example 1 (FIG. 2(b)). Thus, it was understood that Comparative Example 1 yielded poor crystallinity compared with Example 1.

From the above, it is understood that Example 1 of the present invention yields good crystallinity of 3C-SiC and inhibits the phase transition compared with Comparative Example 1.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for manufacturing a heteroepitaxial wafer, epitaxially growing a 3C-SiC single crystal film on a single crystal silicon substrate, the method comprising the steps of:
providing a single crystal silicon substrate having a plane orientation of (111);
removing a natural oxide film on a surface of the single crystal silicon substrate by hydrogen baking using a flashlamp apparatus; and
supplying a source gas containing carbon and silicon into the flashlamp apparatus and growing a SiC single crystal on the surface of the single crystal silicon substrate, wherein
in the step of removing the natural oxide film, the hydrogen baking is performed at 900°C or higher and 1350°C or lower after preheating at 300°C or higher and 600°C or lower, and
in the step of growing the SiC single crystal, SiC nucleation is performed at 900°C or higher and 1350°C or lower after preheating at 300°C or higher and 600°C or lower.

2. The method for manufacturing a heteroepitaxial wafer according to claim 1, wherein
a time for the hydrogen baking at 900°C or higher and 1350°C or lower is set to 10 milliseconds or more and 100 milliseconds or less, and
a time for the SiC nucleation at 900°C or higher and 1350°C or lower is set to 1 millisecond or more and 20 milliseconds or less.

3. The method for manufacturing a heteroepitaxial wafer according to claim 1 or 2, wherein the source gas is at least one of monomethylsilane and trimethylsilane.
